# EUROPÄISCHE PATENTSCHRIFT

(11) **EP 3 601 814 B1**
(45) Veröffentlichungstag und Bekanntmachung des Hinweises auf die Patenterteilung: **14.07.2021**
(21) Anmeldenummer: 18705901.9
(22) Anmeldetag: 15.02.2018
(51) Int. Cl.: F16B 5/06, H05K 5/00

(54) **VERBINDER ZUM VERBINDEN VON ZWEI GEHÄUSETEILEN UND GEHÄUSE UMFASSEND ZWEI GEHÄUSETEILE UND MINDESTENS EINEN VERBINDER**
CONNECTOR FOR CONNECTING TWO HOUSING PARTS AND HOUSING COMPRISING TWO HOUSING PARTS AND AT LEAST ONE CONNECTOR
CONNECTEUR POUR ASSEMBLER DEUX PARTIES DE BOÎTIER ET BOÎTIER COMPRENANT DEUX PARTIES DE BOÎTIER ET AU MOINS UN CONNECTEUR

(30) Priorität: 20.03.2017 DE 102017204600
(43) Veröffentlichungstag der Anmeldung: 05.02.2020
(73) Patentinhaber: Robert Bosch GmbH, 70442 Stuttgart (DE)
(72) Erfinder: MIKLOSI, Zoltan, 1114 Budapest (HU)
(86) Internationale Anmeldenummer: PCT/EP2018/053823
(87) Internationale Veröffentlichungsnummer: WO 2018/171985

(56) Entgegenhaltungen:
- EP-A2- 1 765 047
- DE-A1- 19 642 045
- DE-A1-102007 059 944
- DE-T2- 69 902 828
- US-A1- 2005 225 449

## Beschreibung

Die Erfindung betrifft einen Verbinder zum Verbinden von zwei Gehäuseteilen, wobei ein erster Verbinderteil zur Anordnung an einem ersten Gehäuseteil ausgebildet ist und ein zweiter Verbinderteil zur Anordnung an einem zweiten Gehäuseteil ausgebildet ist, wobei das erste Verbinderteil zumindest ein Federelement sowie ein erstes Schnappelement aufweist und das zweite Verbinderteil ein erstes Rastelement aufweist, wobei das erste Schnappelement eingerichtet ist, bei einem Verbinden des ersten Gehäuseteils und des zweiten Gehäuseteils mit dem Rastelement derart zusammenzuwirken, dass, wenn beim Verbinden der Gehäuseteile das erste Verbinderteil und das zweite Verbinderteil entlang einer Verbindungsrichtung aufeinander zubewegt werden, das Schnappelement unter Auslenkung des mindestens einen Federelements über das erste Rastelement geschoben wird und anschließend das Rastelement und das Schnappelement einen Formschluss ausbilden. Weitere Aspekte der Erfindung betreffen ein Gehäuse umfassend mindestens einen derartigen Verbinder sowie einen Ultraschallsensor umfassend ein solches Gehäuse.

### Stand der Technik

Gehäuse, beispielsweise für elektronische Geräte oder für Sensoren, weisen in der Regel zumindest zwei Gehäuseteile auf. Im Fall eines Gehäuses für einen Sensor hat das Gehäuse die Aufgabe, das Wandlerelement und die zur Ansteuerung des Wandlers notwendige Elektronik aufzunehmen und vor Umwelteinflüssen zu schützen. Besteht das Gehäuse beispielsweise aus zwei Einzelteilen, so können die Komponenten des elektronischen Gerätes oder des Sensors zunächst in eine Hälfte des Gehäuses platziert werden und das Gehäuse anschließend durch Verbinden mit der zweiten Gehäusehälfte verschlossen werden. Für ein schnelles, einfaches und kostengünstiges Verbinden zweier Gehäusehälften sind im Stand der Technik Verbindungssysteme bekannt, bei denen jeweils zwei Elemente, beispielsweise unter Verwendung eines Rasthakens oder eines Schnappelements miteinander verbunden werden.

Aus US 2012/0187812 A1 ist ein Gehäuse mit einer Verriegelungsstruktur zum Verbinden eines ersten Gehäuseteils mit einem zweiten Gehäuseteil bekannt. Die Verriegelungsstruktur weist ein flexibles Schnappelement auf, welches sich vom ersten Gehäuseteil aus entlang der Innenwand des zweiten Gehäuseteils erstreckt und mit einem ersten zusammenarbeitenden Teil versehen ist. Am zweiten Gehäuseteil ist ein zweites zusammenarbeitendes Teil angeordnet, welches mit dem ersten zusammenarbeitenden Teil des Schnappelements einen Formschluss ausbildet. Das zweite zusammenarbeitende Teil weist eine Rampe auf, über die das Schnappelement beim Zusammenstecken gleiten kann. Das Schnappelement weist zwei Schenkel auf, wobei das zweite zusammenarbeitende Teil im verriegelten Zustand zwischen den beiden Schenkeln angeordnet ist.

Das Dokument DE 196 42 045 A1 beschreibt ein Verbinder zum Verbinden von zwei Gehäuseteilen gemäß dem Oberbegriff des Anspruchs 1.

Nachteilig an den bekannten Verbindungselementen ist, dass im Fall einer Verwendung eines Formschlusses dieser üblicherweise ein Spiel aufweist, so dass die über die Verbinder verbundenen Gehäuseteile ebenfalls dieses Spiel aufweisen. Das hat zur Folge, dass das Gehäuse bei Vibrationen klappert. Alternativ dazu verwendete auf einem Kraftschluss basierende Verbinder weisen den Nachteil auf, dass sich die Verbindung zwischen den Gehäuseteilen bei Überschreitung der Haltekraft wieder lösen lässt. Es besteht somit Bedarf nach einem Verbinder, mit dem sich zwei Gehäuseteile sicher und dauerhaft miteinander verbinden lassen, wobei die Verbindung kein Spiel aufweist.

### Offenbarung der Erfindung

Es wird ein Verbinder zum Verbinden von zwei Gehäuseteilen vorgeschlagen, wobei ein erstes Verbinderteil zur Anordnung an einem ersten Gehäuseteil ausgebildet ist und ein zweites Verbinderteil zur Anordnung an einem zweiten Gehäuseteil ausgebildet ist. Das erste Verbinderteil weist mindestens ein Federelement sowie ein erstes Schnappelement auf und das zweite Verbinderteil weist ein erstes Rastelement auf. Das mindestens eine Federelement weist einen Fußpunkt zur Verbindung mit dem ersten Gehäuseteil auf. Das erste Schnappelement ist eingerichtet, bei einem Verbinden des ersten Gehäuseteils und des zweiten Gehäuseteils mit dem ersten Rastelement derart zusammenzuwirken, dass, wenn das erste Verbinderteil und das zweite Verbinderteil entlang einer Verbindungsrichtung aufeinander zubewegt werden, das erste Schnappelement unter Auslenkung des mindestens einen Federelements über das erste Rastelement geschoben wird, wobei anschließend das erste Rastelement und das erste Schnappelement unterstützt durch eine Rückstellkraft des mindestens einen Federelements formschlüssig und kraftschlüssig verbunden sind. Zusätzlich weist das erste Verbinderteil ein zweites Schnappelement auf und das zweite Verbinderteil weist zusätzlich ein zweites Rastelement auf. Das zweite Schnappelement und das zweite Rastelement sind derart ausgestaltet, dass bei einem Aufeinanderzubewegen des ersten Verbinderteils und des zweiten Verbinderteils entlang der Verbindungsrichtung das zweite Schnappelement unter Auslenkung des mindestens einen Federelements über das zweite Rastelement geschoben wird, wobei das zweite Rastelement und das zweite Schnappelement derart geformt sind, dass bei einem Auseinanderbewegen des ersten Verbinderteils und des zweiten Verbinderteils entgegen der Verbindungsrichtung ein Formschluss ausgebildet wird, der ein Zurückschieben des zweiten Schnappelements über das zweite Rastelement verhindert.

Das erste Verbinderteil ist bevorzugt aus einem Kunststoffmaterial gefertigt, wobei das erste Verbinderteil bevorzugt einstückig ausgeführt ist, so dass das mindestens eine Federelement sowie das erste Schnappelement und das zweite Schnappelement ein einziges Bauteil ausbilden. Sofern auch das erste Gehäuseteil aus einem Kunststoff gefertigt wird, ist es des Weiteren bevorzugt, dass das erste Verbinderteil einstückig mit dem ersten Gehäuseteil ausgeführt ist.

Das zweite Verbinderteil umfassend das erste Rastelement und das zweite Rastelement ist bevorzugt einstückig mit dem zweiten Gehäuseteil ausgeführt. Als Material für das zweite Verbinderteil ist ebenfalls ein Kunststoffmaterial geeignet. Dabei kann das Kunststoffmaterial identisch mit dem Kunststoffmaterial des ersten Verbinderteils gewählt werden oder es kann ein anderes Kunststoffmaterial gewählt werden. Des Weiteren ist es denkbar, das zweite Verbinderteil aus einem Metall zu fertigen.

Bevorzugte Kunststoffmaterialien für das erste Verbinderteil und/oder das zweite Verbinderteil umfassen insbesondere thermoplastische Kunststoffe. Der Kunststoff kann zusätzlich mit Fasern, beispielsweise Glasfasern, verstärkt sein. Beispiele für geeignete Kunststoffe umfassen Polybutylenterephthalat (PBT) und mit Glasfasern verstärktes Polyamid.

Bevorzugt weist die in Richtung des Fußpunkts des ersten Verbinderteils weisende Seite des ersten Rastelements mit Bezug zu der Verbindungsrichtung eine erste Rampenform auf und/oder die in Richtung des Fußpunkts des ersten Verbinderteils weisende Seite des zweiten Rastelements weist mit Bezug zu der Verbindungsrichtung eine zweite Rampenform auf, so dass bei einer Bewegung entlang der Verbindungsrichtung das erste Schnappelement auf der ersten Rampenform bzw. das zweite Schnappelement auf der zweiten Rampenform entlanggleitet, wobei das mindestens eine Federelement ausgelenkt wird.

Das zweite Verbinderteil ist dabei bevorzugt im Bereich einer Wand des zweiten Gehäuseteils angeordnet, wobei das erste Rastelement und/oder das zweite Rastelement an diese Gehäusewand angrenzen. Die erste Rampenform des ersten Rastelements bzw. die zweite Rampenform des zweiten Rastelements ist dabei derart ausgeführt, dass die Gehäusewand eine Ebene bildet, auf der das erste Rastelement bzw. das zweite Rastelement angeordnet sind und die Rampenform ist auf dieser Ebene so angeordnet, dass die Rampenform in Richtung des Fußpunkts des ersten Verbinderteils abfällt und bevorzugt an ihrem Ende ohne einen Sprung oder eine Stufe in die von dem Gehäuseteil gebildete Ebene übergeht.

Bevorzugt weist das erste Rastelement auf der dem Fußpunkt des ersten Verbinderteils abgewandten Seite eine dritte Rampenform auf, wobei das erste Schnappelement eine dazu komplementäre Form aufweist. Hierdurch wird gewährleistet, dass aufgrund der Rückstellkraft des mindestens einen Federelements die komplementäre Form des ersten Schnappelements kraftschlüssig mit der auf der abgewandten Seite angeordneten dritten Rampenform des Rastelements verbunden ist, so dass ein Spiel zwischen dem ersten Verbinderteil und dem zweiten Verbinderteil verhindert wird. Dadurch wird vermieden, dass beispielsweise bei einer Vibration die beiden Gehäuseteile klappern können.

Bevorzugt weist das zweite Rastelement auf der dem Fußpunkt des ersten Verbinderteils abgewandten Seite eine zur Verbindungsrichtung senkrechte Fläche auf oder das zweite Rastelement weist auf der dem Fußpunkt des ersten Verbinderteils abgewandten Seite mit Bezug zu einer Richtung senkrecht zur Verbindungsrichtung eine Hinterschneidung auf. Dazu ist es bevorzugt, dass das zweite Schnappelement eine Spitze umfasst, welche eine zu der Form der dem Fußpunkt des ersten Verbinderteil abgewandten Seite des zweiten Rastelements komplementäre Form aufweist. Diese Spitze zeigt in Richtung des Fußpunkts. Hierdurch wird erreicht, dass bei einer Relativbewegung des ersten Verbinderteils mit Bezug auf den zweiten Verbinderteil in einer Richtung entgegen der Verbindungsrichtung das zweite Rastelement und das zweite Schnappelement einen Formschluss ausbilden, der eine Ausweichbewegung verhindert, so dass das zweite Schnappelement nicht über das zweite Rastelement gleiten kann.

Bevorzugt ist das mindestens eine Federelement als Biegebalken ausgestaltet. Des Weiteren ist es bevorzugt, dass das erste Verbinderteil zwei Federelemente aufweist, welche jeweils als Biegebalken ausgestaltet sind, wobei das erste Schnappelement die beiden Federelemente verbindet, so dass eine U-förmige Anordnung gebildet wird. Bei dieser U-förmigen Anordnung bilden die beiden Federelemente die Schenkel der U-Form.

Bevorzugt sind die als Biegebalken ausgestalteten Federelemente derart angeordnet, dass sie parallel zu der Verbindungsrichtung angeordnet sind und beim Verbinden des ersten Verbinderelements mit dem zweiten Verbinderelements in eine Richtung senkrecht zu der Verbindungsrichtung ausgelenkt werden.

Bevorzugt ist das zweite Schnappelement mit dem ersten Schnappelement derart verbunden, dass die beiden Federelemente, das erste Schnappelement und das zweite Schnappelement eine E-förmige Anordnung ausbilden. Dabei bilden die beiden Federelemente jeweils den obersten und den untersten Querbalken des E's aus, das zweite Schnappelement bildet den mittleren Querbalken der E-Form aus und das erste Schnappelement verbindet in der E-Form die Querbalken miteinander.

Das erste Rastelement des zweiten Verbinderteils ist bevorzugt derart ausgestaltet, das es eine Aussparung aufweist, in die das zweite Schnappelement eingreifen kann.

Durch die Aussparung in dem ersten Rastelement sowie gegebenenfalls die weitere Formgestaltung des ersten Rastelements kann beim Zusammenwirken mit dem ersten Verbinderteil, insbesondere mit den Federelementen und dem ersten Schnappelement, zusätzlich zu dem Kraftschluss zwischen dem ersten Schnappelement und dem ersten Rastelement auch ein Formschluss ausgebildet werden.

Ein weiterer Aspekt der Erfindung ist es, ein Gehäuse bereitzustellen, welches ein erstes Gehäuseteil und ein zweites Gehäuseteil aufweist. Das Gehäuse umfasst zudem mindestens einen der beschriebenen Verbinder, wobei ein erstes Verbinderteil am ersten Gehäuseteil angeordnet ist und ein zweites Verbinderteil am zweiten Gehäuseteil angeordnet ist.

Das Gehäuse ist bevorzugt als ein Sensorgehäuse ausgestaltet. Das Sensorgehäuse kann insbesondere als ein Sensorgehäuse für einen Ultraschallsensor ausgebildet sein und neben einem Schallwandler auch eine Elektronik zur Ansteuerung des Schallwandlers aufnehmen.

Ein weiterer Aspekt der Erfindung ist es, einen Ultraschallsensor bereitzustellen, der eines der beschriebenen Gehäuse aufweist. Des Weiteren umfasst der Ultraschallsensor einen Schallwandler und eine Elektronik zur Ansteuerung des Schallwandlers.

### Vorteile der Erfindung

Der vorgeschlagene Verbinder zum Verbinden zweier Gehäuseteile weist zwei zusammenwirkende Verschlussmechanismen auf. Ein erster Verschlussmechanismus, der durch ein erstes Schnappelement und ein erstes Rastelement gebildet wird, bildet dabei einen kombinierten Kraftschluss und Formschluss aus, wobei durch den Kraftschluss in vorteilhafter Weise ein Klappern des Gehäuses bei Einwirken von Vibrationen vermieden wird. Der Kraftschluss verhindert dabei eine Relativbewegung der beiden Gehäuseteile relativ zu einander, solange die auftretenden Kräfte kleiner sind als die Haltekraft des Kraftschlusses.

Für den Fall, dass die auftretenden Kräfte die Haltekraft des Kraftschlusses übersteigen, verhindert der zweite vorgesehene Verbindungsmechanismus ein Trennen der beiden Gehäuseteile. Der zweite Verschlussmechanismus umfasst das zweite Schnappelement und das zweite Rastelement. Wirken Kräfte auf den Verbinder ein, die die Haltekraft des Kraftschlusses des ersten Verschlussmechanismus übersteigen, so beginnen die beiden Verbinderteile sich auseinanderzubewegen. Dabei stößt aber eine Spitze des zweiten Schnappelements auf eine entsprechende komplementäre Form des zweiten Rastelements, wodurch ein Formschluss ausgebildet wird, der eine weitere Bewegung verhindert.

Somit wird durch den zweiten Verschlussmechanismus des vorgeschlagenen Verbinders eine Trennung der beiden Gehäuseteile verhindert, wobei gleichzeitig der erste Verschlussmechanismus ein bei Einwirken einer Vibration auftretendes Klappern der beiden Gehäuseteile verhindert. Der erste Verschlussmechanismus erlaubt es dabei Fertigungstoleranzen und Änderungen der Abmessungen aufgrund von Temperaturänderungen zu kompensieren.

Ein Öffnen der Verbindung ist unter Verwendung eines Werkzeugs möglich, indem die Spitze des zweiten Schnappelements mit dem Werkzeug über das zweite Rastelement gehoben wird. Ein mit dem vorgeschlagenen Verbinder verschlossenes Gehäuse kann somit nur durch Zerstörung des Verbinders oder durch die Verwendung eines speziellen Werkzeuges geöffnet werden, so dass ein unautorisierter Zugriff auf das Gehäuseinnere unterbunden oder zumindest nachweisbar ist.

Vorteilhafterweise geht das Schließen des Verbinders aufgrund der Rückstellbewegung des mindestens einen Federelements mit einem deutlich hörbaren Klicken einher, so dass beim Zusammenbauen des Gehäuses eine Rückmeldung erfolgt.

Der vorgeschlagene Verbinder kann zudem einfach mittels Spritzgießen hergestellt werden, wobei einfache Werkzeuge ohne Schieber ausreichend sind.

### Kurze Beschreibung der Figuren

Ein Ausführungsbeispiel der Erfindung ist in den Zeichnungen dargestellt und in der nachfolgenden Beschreibung näher erläutert.

Es zeigen:
- Figur 1: eine perspektivische Darstellung eines Ausschnitts aus einem Gehäuse mit einem Verbinder,
- Figur 2: eine Draufsicht auf den Verbinder,
- Figur 3: den Verbinder in einer Schnittansicht von der Seite in einem verbundenen Zustand,
- Figur 4: die beiden Verbinderteile des Verbinders in der Schnittansicht von der Seite vor dem Verbinden,
- Figur 5: das Aufeinanderzubewegen der beiden Verbinderteile und
- Figur 6: zeigt das Sperren des Verbinders bei einer Bewegung entgegen der Verbindungsrichtung.

In der nachfolgenden Beschreibung der Ausführungsbeispiele der Erfindung werden gleiche Komponenten und Elemente mit gleichen Bezugszeichen bezeichnet, wobei auf eine wiederholte Beschreibung der Komponenten in Einzelfällen verzichtet wird. Die Figuren stellen den Gegenstand der Erfindung nur schematisch dar.

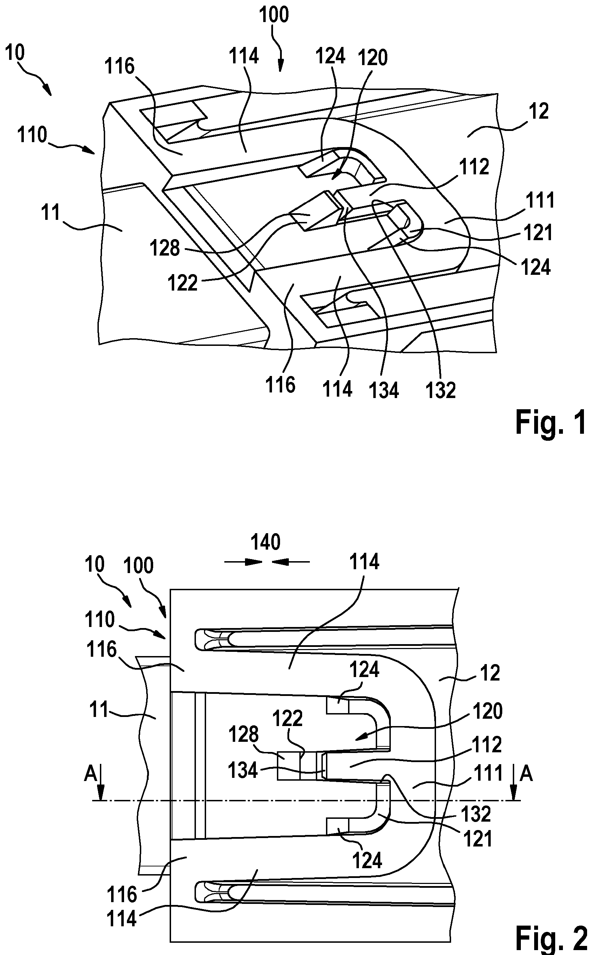

In Figur 1 ist ein Ausschnitt eines Gehäuses 10 dargestellt, welches ein erstes Gehäuseteil 11 und ein zweites Gehäuseteil 12 umfasst. Des Weiteren umfasst das Gehäuse 10 einen Verbinder 100 mit einem ersten Verbinderteil 110, der am ersten Gehäuseteil 11 angeordnet ist, und einem zweiten Verbinderteil 120, der am zweiten Gehäuseteil 12 angeordnet ist. In der Figur 1 ist der Verbinder 100 im verbundenen Zustand dargestellt, das heißt das erste Gehäuseteil 11 und das zweite Gehäuseteil 12 sind durch den Verbinder 100 miteinander verbunden.

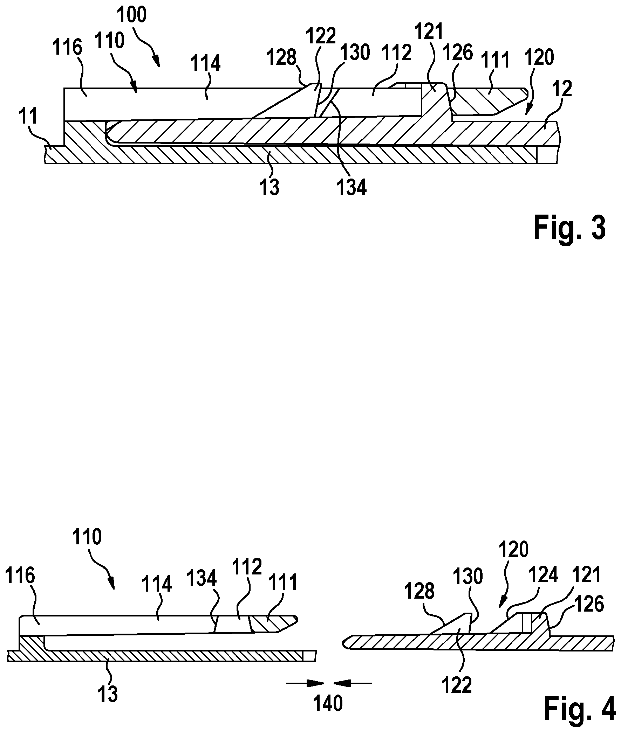

Das erste Verbinderteil 110 weist zwei als Biegebalken ausgestaltete Federelemente 114 auf. Die beiden Federelemente 114 sind dabei im dargestellten nicht ausgelenktem Zustand parallel zu einer Gehäusewand 13 des Gehäuses 10 ausgerichtet, siehe Figur 3. Die beiden Federelemente 114 münden an einem Ende in einen Fußpunkt 116, der mit dem ersten Gehäuseteil 11 verbunden ist, wobei die beiden Federelemente 114 mit dem ersten Gehäuseteil 11 einstückig ausgeführt sind. An ihrem entgegengesetzten Ende münden die beiden Federelemente 114 in ein erstes Schnappelement 111, welches somit die beiden als Biegebalken ausgeführten Federelemente 114 miteinander verbindet. Das erste Schnappelement 111 ist ebenfalls parallel zu der Gehäusewand 13 des Gehäuses 10 ausgerichtet. Ausgehend von der Mitte des ersten Schnappelements 111 erstreckt sich ein zweites Schnappelement 112 ebenfalls parallel zu der Gehäusewand 13 des Gehäuses 10 in Richtung des ersten Gehäuseteils 11. Das zweite Schnappelement 112 ist dabei im Wesentlichen balkenförmig ausgestaltet, wobei die Balkenform parallel zu den Federelementen 114 ausgerichtet ist. Die beiden Federelemente 114 sowie das erste Schnappelement 111 und das zweite Schnappelement 112 bilden dabei eine Form aus, die dem großen Buchstaben "E" ähnelt, wobei die beiden Federelemente 114 jeweils den oberen und den unteren Querbalken der E-Form darstellen, und das zweite Schnappelement 112 den mittleren Querbalken der E-Form darstellt. Das erste Schnappelement 111 verbindet die drei Querbalken der Form miteinander.

Das zweite Verbinderteil 120 umfasst ein erstes Rastelement 121 und ein zweites Rastelement 122, die einstückig mit einem Abschnitt des zweiten Gehäuseteils 12 ausgebildet sind.

In dem in Figur 1 dargestellten verbundenen Zustand des Verbinders 100 ist das erste Schnappelement 111 über das erste Rastelement 121 hinweggeschoben worden, so dass das erste Schnappelement 111 an eine dem ersten Gehäuseteil 11 abgewandten Seite des ersten Rastelements 121 an das erste Rastelement 121 angrenzt. Dabei weist das erste Rastelement 121 eine Aussparung 132 auf, in die das zweite Schnappelement 112 eingreift.

Das zweite Schnappelement 112 ist in der in Figur 1 dargestellten Situation über das zweite Rastelement 122 hinweggeschoben worden, so dass eine Spitze 134 des zweiten Rastelements 122 der dem ersten Gehäuseteil 11 abgewandten Seite des zweiten Rastelements 122 gegenüberliegt.

Das erste Rastelement 121 weist auf der dem Fußpunkt 116 des ersten Verbinderteils 110 zugewandten Seiten eine erste Rampenformen 124 auf und das zweite Rastelement 122 weist auf der dem Fußpunkt 116 des ersten Verbinderteils 110 zugewandten Seiten eine zweite Rampenformen 128 auf. Diese Rampenformen 124, 128 ermöglichen es dem ersten Schnappelement 111 sowie dem zweiten Schnappelement 112 bei einem Zusammenführen des ersten Verbinderteils 110 mit dem zweiten Verbinderteil 120 unter Auslenkung der Federelemente 114 über das erste Rastelement 121 bzw. das zweite Rastelement 122 zu gleiten.

In Figur 2 ist der Verbinder 100 in einer Draufsicht dargestellt. In der Draufsicht ist die E-Form, die durch die beiden Federelemente 114 sowie das erste Schnappelement 111 und das zweite Schnappelement 112 gebildet wird, deutlich zu erkennen. Des Weiteren ist zu erkennen, dass mit Bezug auf eine Verbindungsrichtung 140 die Spitze 134 des zweiten Schnappelements 112 der dem Fußpunkt 116 des ersten Verbinderteils 110 abgewandten Seite des zweiten Rastelements 122 gegenüberliegt. In dem in Figur 2 dargestellten verbundenen Zustand, bei dem keine äußeren Kräfte auf die Verbinder 100 einwirken, berührt die Spitze 134 das zweite Rastelement 122 nicht.

Das erste Schnappelement 111 liegt in dem in Figur 2 dargestellten verbundenen Zustand des Verbinders 100 an dem ersten Rastelement 121 an, wobei das erste Rastelement 121 derart ausgeformt ist, dass zusätzlich zu einem Kraftschluss zwischen dem ersten Schnappelement 111 und dem ersten Rastelement 121 auch ein Formschluss zwischen dem ersten Rastelement 121 und Teilen der Federelemente 114 entsteht.

In der Figur 2 ist ebenfalls zu erkennen, dass das erste Rastelement 121 und das zweite Rastelement 122 jeweils auf ihren dem Fußpunkt 116 des ersten Verbinderteils 110 zugewandten Seiten Rampenformen 124, 128 aufweisen.

Figur 3 zeigt eine Schnittansicht von der Seite auf den Verbinder 100 entlang der in Figur 2 markierten Schnittlinie A-A. Der Verbinder 100 ist dabei in verbundenem Zustand dargestellt, wobei keine äußeren Kräfte auf den Verbinder 100 einwirken.

In der Schnittdarstellung in Figur 3 ist zu erkennen, dass das erste Verbinderteil 110 ein als Biegebalken ausgeführtes Federelement 114 aufweist, welches im Wesentlichen parallel zu der Gehäusewand 13 verläuft und über den Fußpunkt 116 mit dem ersten Gehäuseteil 11 verbunden ist. Dabei weist das Federelement 114 einen Abstand zu der Gehäusewand 13 auf, so dass das zweite Verbinderteil 120 zwischen die Gehäusewand 13 und das Federelement 114 eingreifen kann. Des Weiteren ist zu erkennen, dass das erste Rastelement 121 auch auf der dem Fußpunkt 116 des ersten Verbinderteils 110 abgewandten Seite eine dritte Rampenform 126 aufweist, die mit einer korrespondierenden Form des ersten Schnappelements 111 zusammenwirkt. Das erste Schnappelement 111 wird dabei von einer Rückstellkraft der Federelemente 114 gegen die dritte Rampenform 126 des ersten Rastelements 121 gedrückt, so dass ein Kraftschluss entsteht.

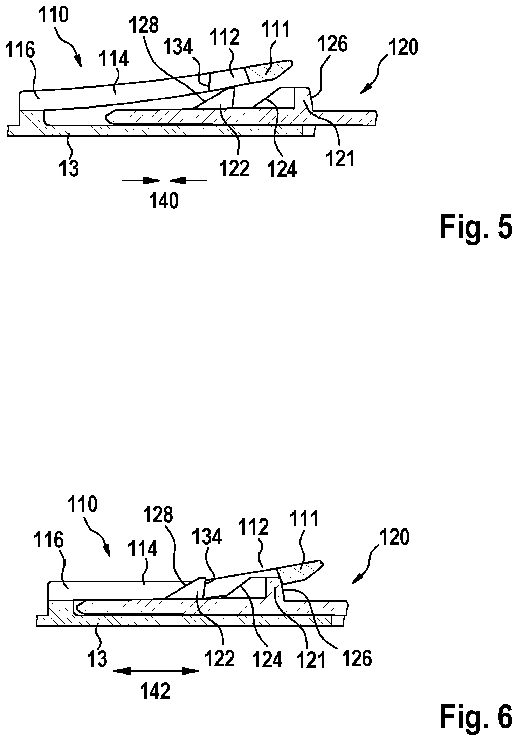

In der Schnittdarstellung der Figur 3 ist zudem zu erkennen, dass das zweite Rastelement 122 auf der dem Fußpunkt 116 des ersten Verbinderteils 110 abgewandten Seite mit Bezug auf eine Richtung senkrecht zu einer durch die Gehäusewand 13 definierten Ebene eine Hinterschneidung 130 aufweist. Die Spitze 134 des zweiten Schnappelements 112 weist eine zu der Hinterschneidung 130 komplementäre Form auf. In dem in Figur 3 dargestellten Zustand des Verbinders 100 wirken auf den Verbinder 100 keine externen Kräfte ein, so dass die Spitze 134 nicht direkt an der Hinterschneidung 130 anliegt. Eine Situation, bei der eine externe Kraft auf den Verbinder 100 einwirkt, ist mit Bezug zur Figur 6 beschrieben.

Figur 4 zeigt den Verbinder 100 mit dem ersten Verbinderteil 110 und dem zweiten Verbinderteil 120 vor dem Verbinden. Für das Verbinden des ersten Verbinderteils 110 mit dem zweiten Verbinderteil 120 werden die beiden Verbinderteile 110, 120 entlang der Verbindungsrichtung 140 aufeinander zubewegt.

In Figur 5 ist das Verbinden des ersten Verbinderteils 110 mit dem zweiten Verbinderteil 120 schematisch dargestellt. Die beiden Verbinderteile 110, 120 werden dabei entlang der Verbindungsrichtung 140 aufeinander zubewegt, wobei in der in Figur 5 dargestellten Situation ein Teil des zweiten Verbinderteils 120 bereits in einen Freiraum zwischen dem Federelement 114 und der Gehäusewand 13 eingreift. Dabei gleitet das zweite Schnappelement 112 entlang der zweiten Rampenform 128 des zweiten Rastelements 122, wobei das Federelement 114 nach oben, also von der Gehäusewand 13 weg, ausgelenkt wird. Sobald das erste Schnappelement 112 auf die erste Rampenform 124 des ersten Rastelements 121 trifft, gleitet dieses auf der ersten Rampenform 124, wobei ebenfalls eine Auslenkung des Federelements 114 bewirkt wird. Nach dem vollständigen Zusammenschieben des ersten Verbinderteils 110 und des zweiten Verbinderteils 120 kehrt das Federelement 114 aufgrund einer Rückstellkraft wieder in seine ursprüngliche Lage zurück, wobei dann, wie in Figur 3 dargestellt, das erste Schnappelement 111 an der dritten Rampenform 126 des ersten Rastelements 121 form- und kraftschlüssig anliegt.

In Figur 6 ist das Einwirken einer externen Kraft auf den Verbinder 100 dargestellt, wobei durch das Einwirken der externen Kraft eine Bewegung der beiden Verbinderteile 110, 120 entgegen der Verbindungsrichtung 140 hervorgerufen wird. Diese Gegenrichtung ist in der Figur 6 mit dem Bezugszeichen 142 bezeichnet. Wie der Darstellung der Figur 6 entnommen werden kann, wird bei einer ausreichend starken externen Krafteinwirkung die Haltekraft des Kraftschlusses zwischen dem ersten Schnappelement 111 und der dritten Rampenform 126 des ersten Rastelements 121 überwunden, so dass das erste Schnappelement 111 unter Auslenkung des Federelements 114 auf der dritten Rampenform 126 nach oben zurückgleitet. Die Bewegung kann jedoch nur solange erfolgen, bis die Spitze 134 des zweiten Schnappelements 112 an der Hinterschneidung 130 des zweiten Rastelements 122 anliegt. Die Hinterschneidung 130 verhindert dabei eine Bewegung nach oben, also von der Gehäusewand 13 weg, so dass eine weitere Auslenkung des Federelements 114 unterbunden wird. Eine Trennung des ersten Verbinderteils 110 von dem zweiten Verbinderteil 120 wird somit verhindert.

Sollen die beiden Verbinderteile 110, 120 dennoch voneinander getrennt werden, so kann dies dadurch ermöglicht werden, dass unter Verwendung eines Werkzeugs, wie beispielsweise eines Schraubenziehers, in den Spalt zwischen der Hinterschneidung 130 und der Spitze 134 eingegriffen wird und mit dem Werkzeug das zweite Schnappelement 112 angehoben wird, also von der Gehäusewand 13 wegbewegt wird. Anschließend kann eine Bewegung entlang der in Figur 6 mit dem Bezugszeichen 142 markierten Gegenrichtung erfolgen, wobei durch das Anheben mit dem Werkzeug das zweite Schnappelement 112 über das zweite Rastelement 122 hinweggeführt.

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen. Dabei können insbesondere die Formen und die Abmessungen der Federelemente 114, des ersten Schnappelements 111, des zweiten Schnappelements 112, des ersten Rastelements 121 und des zweiten Rastelements 122 abweichend von den in den Figuren dargestellten Beispielen gewählt werden.

## Patentansprüche

1. Verbinder (100) zum Verbinden von zwei Gehäuseteilen (11, 12), wobei ein erstes Verbinderteil (110) zur Anordnung an einem ersten Gehäuseteil (11) ausgebildet ist und ein zweites Verbinderteil (120) zur Anordnung an einem zweiten Gehäuseteil (12) ausgebildet ist, wobei das erste Verbinderteil (110) mindestens ein Federelement (114) sowie ein erstes Schnappelement (111) aufweist und das zweite Verbinderteil (120) ein erstes Rastelement (121) aufweist, wobei das mindestens eine Federelement einen Fußpunkt (116) zur Verbindung mit dem ersten Gehäuseteil (11) aufweist und wobei das erste Schnappelement (111) eingerichtet ist, bei einem Verbinden des ersten Gehäuseteils (11) und des zweiten Gehäuseteils (12) mit dem ersten Rastelement (121) derart zusammenzuwirken, dass, wenn das erste Verbinderteil (110) und das zweite Verbinderteil (120) entlang einer Verbindungsrichtung (140) aufeinander zubewegt werden, das erste Schnappelement (111) unter Auslenkung des mindestens einen Federelements (114) über das erste Rastelement (121) geschoben wird, **dadurch gekennzeichnet, dass** anschließend das erste Rastelement (121) und das erste Schnappelement (111) unterstützt durch eine Rückstellkraft des mindestens einen Federelements (114) formschlüssig und kraftschlüssig verbunden sind, wobei das erste Verbinderteil (110) des Weiteren ein zweites Schnappelement (112) aufweist und das zweite Verbinderteil (120) des Weiteren ein zweites Rastelement (122) aufweist, wobei das zweite Schnappelement (112) und das zweite Rastelement (122) derart ausgestaltet sind, dass bei einem Aufeinanderzubewegen des ersten Verbinderteils (110) und des zweiten Verbinderteils (120) das zweite Schnappelement (112) unter Auslenkung des mindestens einen Federelements (114) über das zweite Rastelement (122) geschoben wird, wobei das zweite Rastelement (122) und das zweite Schnappelement (112) derart geformt sind, dass bei einem Auseinanderbewegen des ersten Verbinderteils (110) und des zweiten Verbinderteils (120) entgegen der Verbindungsrichtung (140) ein Formschluss ausgebildet wird, der ein Zurückschieben des zweiten Schnappelements (112) über das zweite Rastelement (122) verhindert.

2. Verbinder (100) nach Anspruch 1, **dadurch gekennzeichnet, dass** die in Richtung des Fußpunkts (116) des ersten Verbinderteils (110) weisende Seite des ersten Rastelements (121) mit Bezug zu der Verbindungsrichtung (140) eine erste Rampenform (124) aufweist und/oder dass die in Richtung des Fußpunkts (116) des ersten Verbinderteils (110) weisende Seite des zweiten Rastelements (122) mit Bezug zu der Verbindungsrichtung (140) eine zweite Rampenform (128) aufweist, so dass bei einer Bewegung entlang der Verbindungsrichtung (140) das erste Schnappelement (111) auf der ersten Rampenform (124) bzw. das zweite Schnappelement (112) auf der zweiten Rampenform (128) entlanggleitet, wobei das mindestens eine Federelement (114) ausgelenkt wird.

3. Verbinder (100) nach Anspruch 1 oder 2, **dadurch gekennzeichnet, dass** das erste Rastelement (121) auf der dem Fußpunkt (116) des ersten Verbinderteils (110) abgewandten Seite eine dritte Rampenform (126) aufweist, wobei das erste Schnappelement (111) eine dazu komplementäre Form aufweist.

4. Verbinder (100) nach Anspruch 1 bis 3, **dadurch gekennzeichnet, dass** das zweite Rastelement (122) auf der dem Fußpunkt (116) des ersten Verbinderteils (110) abgewandten Seite eine zur Verbindungsrichtung (140) senkrechte Fläche aufweist oder mit Bezug zu einer Richtung senkrecht zur Verbindungsrichtung (140) eine Hinterschneidung (130) aufweist.

5. Verbinder (100) nach Anspruch 4, **dadurch gekennzeichnet, dass** das zweite Schnappelement (112) eine Spitze (134) umfasst, welche eine zu der Form der dem Fußpunkt (116) des ersten Verbinderteils (110) abgewandten Seite des zweiten Rastelements (122) komplementäre Form aufweist.

6. Verbinder (100) nach einem der Ansprüche 1 bis 5, **dadurch gekennzeichnet, dass** das erste Verbinderteil (110) zwei Federelemente (114) aufweist, welche jeweils als Biegebalken ausgestaltet sind, wobei das erste Schnappelement (111) die beiden Federelemente (114) verbindet, so dass eine U-förmige Anordnung gebildet wird.

7. Verbinder (100) nach Anspruch 6, **dadurch gekennzeichnet, dass** das zweite Schnappelement (112) mit dem ersten Schnappelement (111) verbunden ist, so dass die beiden Federelemente (114), das erste Schnappelement (111) und das zweite Schnappelement (112) eine E-förmige Anordnung ausbilden.

8. Verbinder (100) nach Anspruch 7, **dadurch gekennzeichnet, dass** das erste Rastelement (121) eine Aussparung (132) aufweist, in die das zweite Schnappelement (112) eingreifen kann.

9. Gehäuse (10) mit einem ersten Gehäuseteil (11) und einem zweiten Gehäuseteil (12) **dadurch gekennzeichnet, dass** das Gehäuse (10) mindestens einen Verbinder (100) nach einem der Ansprüche 1 bis 8 umfasst, wobei ein erstes Verbinderteil (110) am ersten Gehäuseteil (11) und ein zweites Verbinderteil (120) am zweiten Gehäuseteil (12) angeordnet ist.

10. Ultraschallsensor umfassend ein Gehäuse (10) nach Anspruch 9.

## Claims

1. Connector (100) for connecting two housing parts (11, 12), wherein a first connector part (110) is designed for arranging on a first housing part (11) and a second connector part (120) is designed for arranging on a second housing part (12), wherein the first connector part (110) has at least one spring element (114) and a first snap-action element (111) and the second connector part (120) has a first latching element (121), wherein the at least one spring element has a foot point (116) for connecting to the first housing part (11), and wherein the first snap-action element (111) is configured to interact with the first latching element (121), when the first housing part (11) is connected to the second housing part (12), in such a manner that, when the first connector part (110) and the second connector part (120) are moved towards each other along a connecting direction (140), the first snap-action element (111) is pushed over the first latching element (121) by deflection of the at least one spring element (114), **characterized in that** the first latching element (121) and the first snap-action element (111), assisted by a restoring force of the at least one spring element (114), are subsequently connected in a form-fitting and force-fitting manner, wherein the first connector part (110) furthermore has a second snap-action element (112) and the second connector part (120) furthermore has a second latching element (122), wherein the second snap-action element (112) and the second latching element (122) are configured in such a manner that, when the first connector part (110) and the second connector part (120) are moved towards each other, the second snap-action element (112) is pushed over the second latching element (122) by deflection of the at least one spring element (114), wherein the second latching element (122) and the second snap-action element (112) are formed in such a manner that, when the first connector part (110) and the second connector part (120) are moved apart counter to the connecting direction (140), a form-fitting connection is formed, preventing the second snap-action element (112) from sliding back over the second latching element (122) .

2. Connector (100) according to Claim 1, **characterized in that** the side of the first latching element (121) facing towards the foot point (116) of the first connector part (110) has a first ramp shape (124) with respect to the connecting direction (140), and/or **in that** the side of the second latching element (122) facing towards the foot point (116) of the first connector part (110) has a second ramp shape (128) with respect to the connecting direction (140) such that, during a movement along the connecting direction (140), the first snap-action element (111) slides along on the first ramp shape (124) or the second snap-action element (112) slides along on the second ramp shape (128), with the at least one spring element (114) being deflected.

3. Connector (100) according to Claim 1 or 2, **characterized in that** the first latching element (121) has a third ramp shape (126) on the side facing away from the foot point (116) of the first connector part (110), wherein the first snap-action element (111) has a shape which is complementary with respect thereto.

4. Connector (100) according to Claims 1 to 3, **characterized in that** the second latching element (122) has a surface perpendicular to the connecting direction (140) or has an undercut (130) with respect to a direction perpendicular to the connecting direction (140), on the side facing away from the foot point (116) of the first connector part (110).

5. Connector (100) according to Claim 4, **characterized in that** the second snap-action element (112) comprises a point (134) which has a shape which is complementary to the shape of the side of the second latching element (122) facing away from the foot point (116) of the first connector part (110).

6. Connector (100) according to one of Claims 1 to 5, **characterized in that** the first connector part (110) has two spring elements (114) which are each configured as bending bars, wherein the first snap-action element (111) connects the two spring elements (114) such that a U-shaped arrangement is formed.

7. Connector (100) according to Claim 6, **characterized in that** the second snap-action element (112) is connected to the first snap-action element (111) such that the two spring elements (114), the first snap-action element (111) and the second snap-action element (112) form an E-shaped arrangement.

8. Connector (100) according to Claim 7, **characterized in that** the first latching element (121) has a recess (132) in which the second snap-action element (112) can engage.

9. Housing (10) having a first housing part (11) and a second housing part (12), **characterized in that** the housing (10) comprises at least one connector (100) according to one of Claims 1 to 8, wherein a first connector part (110) is arranged on the first housing part (11) and a second connector part (120) is arranged on the second housing part (12).

10. Ultrasonic sensor comprising a housing (10) according to Claim 9.

## Revendications

1. Connecteur (100) permettant de connecter deux parties de boîtier (11, 12), une première partie de connecteur (110) étant réalisée pour être disposée sur une première partie de boîtier (11) et une deuxième partie de connecteur (120) étant réalisée pour être disposée sur une deuxième partie de boîtier (12), la première partie de connecteur (110) comprenant au moins un élément ressort (114) ainsi qu'un premier élément d'encliquetage (111) et la deuxième partie de connecteur (120) comprenant un premier élément d'arrêt (121), l'au moins un élément ressort comprenant un point de base (116) pour la connexion à la première partie de boîtier (11) et le premier élément d'encliquetage (111) étant conçu pour coopérer avec le premier élément d'arrêt (121) en cas de connexion de la première partie de boîtier (11) et de la deuxième partie de boîtier (12), de telle sorte que lorsque la première partie de connecteur (110) et la deuxième partie de connecteur (120) sont déplacées l'une vers l'autre le long d'un sens de connexion (140), le premier élément d'encliquetage (111) est poussé sur le premier élément d'arrêt (121) avec déviation de l'au moins un élément ressort (114), **caractérisé en ce qu'**ensuite le premier élément d'arrêt (121) et le premier élément d'encliquetage (111) sont connectés par complémentarité de forme et par force de manière assistée par une force de rappel de l'au moins un élément ressort (114), la première partie de connecteur (110) comprenant en outre un deuxième élément d'encliquetage (112) et la deuxième partie de connecteur (120) comprenant en outre un deuxième élément d'arrêt (122), le deuxième élément d'encliquetage (112) et le deuxième élément d'arrêt (122) étant configurés de telle sorte qu'en cas de rapprochement de la première partie de connecteur (110) et de la deuxième partie de connecteur (120), le deuxième élément d'encliquetage (112) est poussé sur le deuxième élément d'arrêt (122) avec déviation de l'au moins un élément ressort (114), le deuxième élément d'arrêt (122) et le deuxième élément d'encliquetage (112) étant déformés de telle sorte qu'en cas d'éloignement de la première partie de connecteur (110) et de la deuxième partie de connecteur (120) l'une de l'autre en sens inverse du sens de connexion (140), une complémentarité de forme est réalisée, laquelle empêche que le deuxième élément d'encliquetage (112) soit poussé en arrière sur le deuxième élément d'arrêt (122).

2. Connecteur (100) selon la revendication 1, **caractérisé en ce que** le côté du premier élément d'arrêt (121) orienté en direction du point de base (116) de la première partie de connecteur (110) présente par rapport au sens de connexion (140) une première forme de rampe (124) et/ou **en ce que** le côté du deuxième élément d'arrêt (122) orienté en direction du point de base (116) de la première partie de connecteur (110) présente par rapport au sens de connexion (140) une deuxième forme de rampe (128), de sorte qu'en cas de déplacement le long du sens de connexion (140), le premier élément d'encliquetage (111) glisse sur la première forme de rampe (124) le long de celle-ci ou le deuxième élément d'encliquetage (112) glisse sur la deuxième forme de rampe (128) le long de celle-ci, l'au moins un élément ressort (114) étant dévié.

3. Connecteur (100) selon la revendication 1 ou 2, **caractérisé en ce que** le premier élément d'arrêt (121) comprend, sur le côté opposé au point de base (116) de la première partie de connecteur (110), une troisième forme de rampe (126), le premier élément d'encliquetage (111) présentant une forme complémentaire à celle-ci.

4. Connecteur (100) selon les revendications 1 à 3, **caractérisé en ce que** le deuxième élément d'arrêt (122) comprend, sur le côté opposé au point de base (116) de la première partie de connecteur (110), une surface perpendiculaire au sens de connexion (140) ou comprend une contre-dépouille (130) par rapport à une direction perpendiculaire au sens de connexion (140).

5. Connecteur (100) selon la revendication 4, **caractérisé en ce que** le deuxième élément d'encliquetage (112) comporte une pointe (134), laquelle présente une forme complémentaire à la forme du côté du deuxième élément d'arrêt (122) opposé au point de base (116) de la première partie de connecteur (110).

6. Connecteur (100) selon l'une des revendications 1 à 5, **caractérisé en ce que** la première partie de connecteur (110) comprend deux éléments ressorts (114), lesquels sont configurés respectivement comme barre de flexion, le premier élément d'encliquetage (111) connectant les deux éléments ressorts (114), de sorte qu'une disposition en forme de U soit formée.

7. Connecteur (100) selon la revendication 6, **caractérisé en ce que** le deuxième élément d'encliquetage (112) est connecté au premier élément d'encliquetage (111), de sorte que les deux éléments ressorts (114), le premier élément d'encliquetage (111) et le deuxième élément d'encliquetage (112) forment une disposition en forme de E.

8. Connecteur (100) selon la revendication 7, **caractérisé en ce que** le premier élément d'arrêt (121) comprend un évidement (132) dans lequel le deuxième élément d'encliquetage (112) peut venir en prise.

9. Boîtier (10) comportant une première partie de boîtier (11) et une deuxième partie de boîtier (12), **caractérisé en ce que** le boîtier (10) comporte au moins un connecteur (100) selon l'une des revendications 1 à 8, une première partie de connecteur (110) étant disposée sur la première partie de boîtier (11) et une deuxième partie de connecteur (120) étant disposée sur la deuxième partie de boîtier (12).

10. Capteur à ultrasons comportant un boîtier (10) selon la revendication 9.
